# EUROPEAN PATENT APPLICATION

(11) **EP 0 602 659 A1**
(43) Date of publication of application: **22.06.1994**
(21) Application number: 93120381.4
(22) Date of filing: 17.12.1993
(51) Int. Cl.: H04B 10/14, H04B 10/16, H01S 3/103

(54) **Method of removing frequency modulation from amplitude modulated optical signals**

(30) Priority: 17.12.1992 IT TO921016
(71) Applicant: CSELT Centro Studi e Laboratori Telecomunicazioni S.p.A., I-10148 Turin (IT)
(72) Inventor: Cavaciuti, Alessandro, Torino (IT); Puleo, Mario, Borgosesia (Vercelli) (IT)
(74) Representative: Riederer Freiherr von Paar zu Schönau, Anton

(57) **Abstract**

A laser device, directly amplitude modulated, exhibits an unwanted frequency modulation which broadens its emission spectrum. The method eliminates unwanted frequency modulation by carrying out a conversion of modulated optical signal wavelength, by using a semiconductor optical amplifier as a converter and another non-modulated laser as a conversion signal generator. Wavelength conversion takes place in the amplifier due to the effect of its gain modulation induced by saturation. The output signal at the conversion signal frequency, outcoming from the converter and passing a filter, presents an amplitude modulation equal and opposite to that of the modulated signal at the input, but does not show frequency modulation.

## Description

The present invention relates to switching and to long distance transmission of modulated optical signals, and more particularly it concerns a method of removing frequency modulation from amplitude modulated optical signals.

It is known that in long distance transmission, the modulated optical carrier must have a very narrow spectrum. This characteristic is necessary to limit temporal widening of the pulse due to the optical fibers chromatic dispersion, causing a reduction of the maximum transmission rate.

A very narrow spectrum is also required in transmission and switching systems with high density wavelength multiplexing, where wavelengths allocated to the various channels are very close. In this case optical signals must transit very selective bandpass filters to be individually extracted. Consequently, the spectrum of each channel must have a limited width so as to avoid interferences to adjacent channels or to undergo distortions.

In optical transmission systems, the carrier is generated by means of laser devices, for example of the DFB type, which have, in the absence of modulation, a very narrow emission spectrum. When they are directly amplitude modulated, i.e. when their bias current is modulated, the optical signal emitted has a broadening of the spectral line due to the frequency modulation, which makes it unsuitable for the described purposes.

It is possible to obviate this inconvenience by keeping the laser source always active and by modulating the emitted radiation with an external device. This device, acting as an optical modulator, can be realized by means of an optical guide interferometric structure as described for example in the article "8-Gbit/s Transmission Experiment over 68 km of Optical Fiber using a Ti:LiNbO₃ External Modulator" by S.K. Korotky et al, in Journal of Lightwave Technology, Vol. LT-5, n.10., 10-10-1987, pages 1505-1509, or by means of an electro-absorption modulator, as described for example in the paper "Experimental study of InGaAs-InP MQW electro- absorption modulators" by D.R.P. Guy et al., in IEEE Proceedings, Vol. 136, Pt J. Optoelectronics, n.1, Feb. 1989, pages 46-51, where the optical transmittance of the device is modulated by applying a suitable electrical signal.

The use of an external modulator allows to obtain an amplitude modulated signal with a minimum spectral broadening, since the frequency modulation due to laser direct modulation is avoided , but it has some drawbacks:
- a loss of a few dB of optical power are introduced;
- driving voltages of a few volts are required which are difficult to obtain when the modulating signal has a high bit rate;
- a DC voltage level must be applied keeping optimal the operating point of the modulator as the environmental conditions change, by compensating a possible drift;
- the cost of these devices is generally high.

The method of removing frequency modulation from amplitude modulated optical signals, provided by the present invention, obviates these drawbacks since it allows to obtain a modulated optical signal with a spectral broadening near the theoretical minimum, by using a directly modulated laser, it does not produce attenuations of the emitted optical power, which is amplified instead, it does not have drift problems and it allows realizing an integrated system on only one chip, since all the components can be realized with the same technology as that of the semiconductors.

A particular object of the present invention is a method of removing frequency modulation from amplitude modulated optical signals, as described in the characteristic part of the claim.

The foregoing and other characteristics of the present invention will be made clearer by the following description of a preferred embodiment thereof, given by way of a nonlimiting example and with reference to the annexed drawing where is represented a block diagram of the realized system according to the invention.

The method provided by the invention consists in carrying out a conversion of the optical wavelength of the modulated signal, by using a modulated laser, a semiconductor optical amplifier as a converter and another, non-modulated laser as a conversion signal generator. Wavelength con version takes place at conversion signal frequency in the amplifier due to its gain modulation induced by saturation. The output signal at the conversion signal frequency shows, at the output from the converter, an amplitude modulation equal and opposite to that of the input modulated signal, but it does not show any frequency modulation.

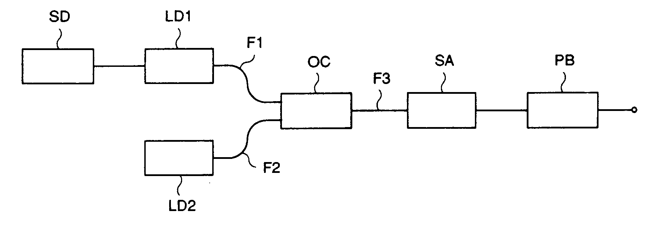

In the figure, a laser LD1 is directly amplitude modulated by a data source SD, and it produces at its output on the optical fiber F1 an optical signal with wavelength λ1, with a broadened emission spectrum due to frequency modulation. A second laser LD2 emits towards the optical fiber F2 a non-modulated optical signal with wavelength λ2, different from λ1, and with a minimum spectral width. These two signals are added by means of an optical coupler OC and sent by an optical fiber F3 to a semiconductor optical amplifier SA.

The gain of the amplifier, which is a function of total power at its input, attains a minimum value due to saturation for sufficiently high power levels. Time dyna mics of gain is such that it allows following very fast variations of the power level at the input. Consequently the gain shows in the course of time a behaviour correlated with the signal modulating the laser LD1. In particular, when the data signal level emitted by SD is high (logic level 1), the gain is reduced with respect to when the data signal level is low (logic level 0).

The gain of the optical amplifier, modulated as a consequence of saturation induced by the modulation applied to the signal at wavelength λ1, is also modulated for any optical signal belonging to the operating spectrum of the amplifier. I.e., once the amplifier gain is modulated by a strong modulated signal, even all the other signals which pass through the amplifier undergo an amplification, which is not constant but which is modulated too. This causes also the radiation coming from the second laser LD2 with wavelength λ2 to undergo an amplification varying in the course of time and therefore to be modulated at the output of the semiconductor optical amplifier SA. In particular, modulation is inverted with respect to that of the signal supplied by laser LD1.

Since the gain saturation effect of the semiconductor amplifier depends on the power of the signal emitted by laser LD1, but not on its emission spectrum, broadened because of direct modulation, the modulated signal spectrum at wavelength λ2, at the output from amplifier SA, results in still having the minimum spectral broadening peculiar for signals modulated in amplitude only.

By means of an optical bandpass filter PB, the optical signal with wavelength λ2 is separated from the signal with wavelength λ1 and made available at the output for transmission. Filter selectivity must be such as to allow the separation between the two wavelengths λ1 and λ2, which must not be equal.

It is clear that what described has been given by way of non limiting example. Variations and modifications are possible without going out of the scope of the claim.

## Claims

1. Method of removing frequency modulation from amplitude modulated optical signals, generated at a first wavelength (λ1) by a first laser device (LD1) directly amplitude modulated by a data source (SD), characterized in that a conversion of the first wavelength (λ1) is carried out into a second wavelength (λ2) by using a non-modulated coversion signal at the second wavelength (λ2) differing from first wavelength (λ1), which is added by an optical coupler (OC) to the modulated optical signal, the added signals together being sent to a semiconductor optical amplifier (SA) which carries out the wavelength conversion by effect of its gain modulation induced by saturation in correspondence to high levels of optical power at the first wavelength (λ1) at its input, the resultantly modulated signal at the second wavelength (λ2) being outputted from the optical amplifier (SA) and being separated by means of selective filtering (PB).
